# EUROPÄISCHE PATENTSCHRIFT

(11) **EP 2 629 911 B1**
(45) Veröffentlichungstag und Bekanntmachung des Hinweises auf die Patenterteilung: **22.07.2020**
(21) Anmeldenummer: 11763905.4
(22) Anmeldetag: 23.09.2011
(51) Int. Cl.: B22F 1/02, C22C 1/05, B22F 1/00, H01L 21/60

(54) **AUSGANGSWERKSTOFF EINER SINTERVERBINDUNG UND VERFAHREN ZUR HERSTELLUNG DER SINTERVERBINDUNG**
STARTER MATERIAL FOR A SINTERING COMPOUND AND METHOD FOR PRODUCING SAID SINTERING COMPOUND
MATÉRIAU DE DÉPART D'UN ASSEMBLAGE PAR FRITTAGE ET PROCÉDÉ DE RÉALISATION D'UN ASSEMBLAGE PAR FRITTAGE

(30) Priorität: 20.10.2010 DE 102010042721
(43) Veröffentlichungstag der Anmeldung: 28.08.2013
(73) Patentinhaber: Robert Bosch GmbH, 70442 Stuttgart (DE)
(72) Erfinder: WOLDE-GIORGIS, Daniel, 70771 Leinfelden-Echterdingen (DE); FEIOCK, Andrea, 72124 Pliezhausen (DE)
(86) Internationale Anmeldenummer: PCT/EP2011/066620
(87) Internationale Veröffentlichungsnummer: WO 2012/052252

(56) Entgegenhaltungen:
- EP-A1- 1 716 947
- EP-A1- 1 749 600
- EP-A1- 1 950 767
- WO-A1-2009/122467
- WO-A1-2010/081752
- US-A1- 2008 173 398

## Beschreibung

Die Erfindung betrifft einen Ausgangswerkstoff für eine Sinterverbindung und ein Verfahren zu deren Herstellung.

### Stand der Technik

Leistungselektronik wird in vielen Bereichen der Technik eingesetzt. Gerade in elektrischen oder elektronischen Geräten, in welchen große Ströme fließen, ist der Einsatz von Leistungselektronik unumgänglich. Die in der Leistungselektronik notwendigen Stromstärken führen zu einer Eigenerwärmung der enthaltenen elektrischen oder elektronischen Komponenten. Eine weitere thermische Belastung ist gegeben durch den Einsatz derartiger elektrischer oder elektronischer Geräte an Betriebsorten mit gegenüber der Raumtemperatur deutlich erhöhter Temperatur. Als Beispiele sind Steuergeräte im Automobilbereich zu nennen, die unmittelbar im Motorraum angeordnet sind. Dabei ist das Steuergerät zusätzlich einem ständigen Temperaturwechsel ausgesetzt, wodurch die enthaltenen elektrischen und/oder elektronischen Komponenten stark thermisch belastet werden. Im Allgemeinen sind Temperaturwechsel in einem Bereich bis zu einer Temperatur von 200 Grad Celsius üblich. Es werden jedoch zunehmend auch darüber hinaus gehende Einsatztemperaturen gefordert. Dadurch werden insgesamt erhöhte Anforderungen an die Zuverlässigkeit und die Funktionssicherheit von elektrischen oder elektronischen Geräten mit Leistungselektronik gestellt.

Üblicherweise erfolgt eine Anbindung von elektrischen oder elektronischen Komponenten - beispielsweise auf ein Trägersubstrat - durch eine Verbindungsschicht. Als eine derartige Verbindungsschicht sind Lotverbindungen, beispielsweise aus Zinn-Silber oder Zinn-Silber-Kupfer, bekannt. Bei höheren Einsatztemperaturen sind bleihaltige Lotverbindungen einsetzbar. Bleihaltige Lotverbindungen sind jedoch durch gesetzliche Bestimmungen aus Gründen des Umweltschutzes hinsichtlich ihrer zulässigen technischen Anwendungen stark beschränkt. Alternativ bieten sich für den Einsatz bei erhöhten bzw. hohen Temperaturen, insbesondere über 200 Grad Celsius, bleifreie Hartlote an. Bleifreie Hartlote weisen in der Regel einen höheren Schmelzpunkt als 200°C auf. Problematisch daran ist, dass bei der Verwendung von Hartlot zur Ausbildung einer Verbindungsschicht nur wenige elektrische oder elektronische Komponenten als Fügepartner in Frage kommen, die den hohen Temperaturen beim Schmelzen der Hartlote standhalten können.

Eingesetzt werden auch Sinterverbindungen, die bereits bei niedrigen Temperaturen verarbeitet werden können und die dennoch für einen Betrieb bei erhöhten Temperaturen geeignet sind. So zeigt die Patentanmeldung DE 102007046901 A1 derartige Sinterverbindungen. Zur Herstellung einer Sinterverbindung wird ein pastenförmiger Ausgangswerkstoff umfassend leicht zersetzbare Silberverbindungen sowie Silberflocken oder Nanosilber verwendet. Weiterhin kann im Ausgangswerkstoff beispielsweise Kupfer enthalten sein. Zur Ausbildung der Pastenform werden Lösungsmittel beigemischt. Bei einer Temperaturbehandlung des Ausgangswerkstoffs unter 300°C zersetzen sich die Silberverbindungen unter Ausbildung des elementaren Silbers und bilden zusammen mit den Silberflocken und dem Nanosilber die Sinterverbindung aus. Die Sinterverbindung wird eingesetzt zum Kontaktieren zweier Elemente. Die Kontaktierung kann bei einer Verwendung des beschriebenen Ausgangswerkstoffes bereits bei niedrigen Anpressdrücken der Kontaktierungspartner erfolgen.

Die DE 60221433 T2 offenbart eine Sinterverbindung, die aus einer Paste hergestellt wird, welche Partikel aus einer Silberverbindung enthält. Neben den Partikeln aus der Silberverbindung ist auch ein Reduktionsmittel in gelöster Form enthalten. Bei einer Temperaturbehandlung der Sinterpaste unterhalb von 200°C wird die Silberverbindung zum elementaren Silber reduziert unter Bildung der Sinterverbindung.

Die US6951666 zeigt die Herstellung unterschiedlicher Sinterverbindungen. Dabei werden allgemeine Kombinationsmöglichkeiten verschiedener Ausgangselemente beschrieben. Als Ausgangselemente sind unter Anderem molekulare Metalle, zahlreiche metallische Partikel in Nano- oder Mikrogröße, Beschichtungen, Lösungsmittel, Additive, reduzierende Mittel, Kristallisationshemmer, Benetzungsmittel und weitere genannt.

Aus der Offenlegungsschrift WO2009/122467 A1 ist eine Pastenzusammensetzung zur Verbindung von metallischen Komponenten offenbart, bei welcher Metallpartikel mit einer organischen, wasserabweisenden, nicht-Amin-basierten Beschichtung versehen sind.

In der Offenlegungsschrift EP1716947 A1 wird die Herstellung von metallischen Nanopartikeln beschrieben, die eine Sinterverbindung bei niedrigen Temperaturen ermöglicht. Mittels eines chemischen Prozesses werden Ausgangsmaterialien innerhalb einer Myristylalkohollösung zu Partikeln mit einem metallischen Kern und einer physisch an den Kern angebundenen organischen Beschichtung gewandelt.

Die Offenlegungsschrift US20080173398 A1 zeigt ein Verbindungsmaterial aus mit einer organischen Substanz beschichteten Metallpartikel unterschiedlicher Größe.

### Offenbarung der Erfindung

### Vorteile

Der Erfindung liegt die Aufgabe zu Grunde, einen Ausgangswerkstoff für eine Sinterverbindung bereitzustellen, mit welchem in einfacher Weise eine Sinterverbindung bei niedrigen Verarbeitungstemperaturen und -drücken hergestellt werden kann.

Diese Aufgabe wird durch einen Ausgangswerkstoff für eine Sinterverbindung und ein Verfahren zu deren Herstellung mit den Merkmalen der unabhängigen Ansprüche 1 und 11 gelöst.

Das Silbercarbonat, das Silberlactat, das Silberstearat oder das Natriumcarbonat werden nachfolgend als die erfindungsgemäße Metallverbindung bezeichnet.

Die erste und/oder zweite Beschichtung umschließen dabei in vorteilhafter Weise jeweils die ersten Partikel bzw. den metallischen Kern der zweiten Partikel im Wesentlich vollständig, zumindest jedoch nahezu vollständig. Dadurch wirken die erste und/oder die zweite Beschichtung jeweils wie ein Schutzmantel, mittels welchem sichergestellt werden kann, dass die ersten Partikel sowie der in der zweiten Beschichtung enthaltene Anteil an der erfindungsgemäßen Metallverbindung und/oder dem Edelmetalloxid chemisch unverändert bleibt. Somit sind die ersten und die zweiten Partikel bzw. der Ausgangswerkstoff umfassend die ersten und zweiten Partikel bis zur Herstellung einer Sinterverbindung lagerungsfähig.

Durch Aufbringen der ersten Beschichtung auf die ersten Partikeln ist das in der ersten Beschichtung enthaltene Reduktionsmittel sowohl auf den ersten Partikeln selbst als auch insgesamt im Ausgangswerkstoff sehr gleichmäßig und fein verteilt. Dadurch kann der bei einer Temperaturbehandlung des Ausgangswerkstoffs stattfindende Reduktionsprozess innerhalb des Ausgangswerkstoffes einheitlich erfolgen. Daraus resultiert der Vorteil, dass eine aus dem erfindungsgemäßen Ausgangswerkstoff hergestellte Sinterverbindung ein sehr homogenes Sintergefüge aufweist.

Auf Grund des Auftragens in Form einer ersten Beschichtung auf den ersten Partikel ist das Reduktionsmittel in vorteilhafter Weise dadurch auch nächstmöglich zu den zweiten Partikeln, insbesondere zu deren in der zweiten Beschichtung enthaltenem Anteil an der erfindungsgemäßen Metallverbindung und/oder dem Edelmetalloxid, als Reduktionspartner positioniert. Dadurch erfolgt der Reduktionsprozess besonders optimiert. Zusätzlich erfolgt die Umwandlung der erfindungsgemäßen Metallverbindung und/oder des Edelmetalloxids zu dem zugrunde liegenden elementaren Metall bzw. Edelmetall sehr schnell, da sich der Reduktionsprozess im Ausgangswerkstoff nur auf die zweite Beschichtung beschränkt. Dies wird weiter begünstig, je geringer die Schichtdicke der zweiten Beschichtung ausgeführt ist. Vorzugsweise nimmt daher der metallische Kern einen großen Anteil am Volumen der zweiten Partikel ein, während hingegen die zweite Beschichtung mit einer insbesondere kleinen Beschichtungsschichtdicke einen verhältnismäßig geringen Mengenanteil an den zweiten Partikeln ausmacht. Hierbei ist besonders vorteilhaft, dass auf diese Weise zusätzlich Bedingungen vorliegen, die bei einer ausreichenden Menge an Reduktionsmittel zu einer Umwandlung nahezu des gesamten - bevorzugt des gesamten - im Ausgangswerkstoff vorliegenden Anteils der in der zweiten Beschichtung enthaltenen erfindungsgemäßen Metallverbindung und/oder dem Edelmetalloxid zu dem elementaren Metall bzw. Edelmetall führen. In günstiger Weise ergibt sich dann eine besonders hohe thermische und/oder elektrische Leitfähigkeit der aus dem erfindungsgemäßen Ausgangswerkstoff hergestellten Sinterverbindungen. Zusätzlich fallen infolge des Reduktionsprozesses nur geringe Mengen an gasförmigen Nebenprodukten an.

Durch die in den abhängigen Ansprüchen aufgeführten Maßnahmen sind vorteilhafte Weiterbildungen und Verbesserungen des im unabhängigen Anspruch angegebenen Ausgangswerkstoffs möglich.

Die im Ausgangswerkstoff enthaltenen ersten Partikel enthalten bevorzugt ein Edelmetall und/oder Kupfer. Besonders bevorzugt werden als Edelmetall Silber, Gold, Platin und/oder Palladium verwendet.

Die im Ausgangswerkstoff enthaltenen zweiten Partikel umfassen bevorzugt eine zweite Beschichtung, in welcher die enthaltene erfindungsgemäße Metallverbindung und/oder das Metalloxid die gleiche metallische Basis aufweisen, wie die ersten Partikel und/oder der metallische Kern der zweiten Partikel. Ebenso denkbar ist jedoch auch, dass sich die metallische Basis der erfindungsgemäßen Metallverbindung bzw. des Edelmetalloxids in der zweiten Beschichtung vom Werkstoff der ersten Partikel und/oder dem metallischen Kern der zweiten Partikel unterscheidet.

Es besteht eine vorteilhafte Möglichkeit, im Ausgangswerkstoff Variationen an zweite Partikel vorzusehen, die sich in Bezug auf ihren metallischen Kern und/oder ihre auf den metallischen Kern aufgetragene zweite Beschichtung unterscheiden. So können im Ausgangswerkstoff als eine Variation zweite Partikel mit einem Kern aus einem ersten Metall und zweite Partikel mit einem Kern zumindest eines zweiten Metalls enthalten sein. Ferner kann im Ausgangswerkstoff auch eine weitere Variation der zweiten Partikel enthalten sein, wobei zweite Partikel mit einem metallischen Kern und einer auf diesem aufgetragenen ersten Beschichtung aus zumindest einer ersten erfindungsgemäßen Metallverbindung und/oder einem ersten Edelmetalloxid und zweite Partikel mit einem metallischen Kern und einer auf diesem aufgetragenen ersten Beschichtung aus zumindest einer zweiten erfindungsgemäßen Metallverbindung und/oder zumindest einem zweiten Edelmetalloxid vorgesehen werden.

Bei einer vorteilhaften Form der zweiten Partikel ist der metallische Kern im Wesentlichen aus Kupfer oder einem Edelmetall gebildet. Besonders vorteilhaft ist ein metallischer Kern aus Silber, Gold, Platin und/oder Palladium. Ferner ist ein derart ausgeführter Kern der zweiten Partikel bevorzugt mit einer zweiten Beschichtung aus Silber oder Silberoxid versehen.

In einer weiteren vorteilhaften Form der zweiten Partikel ist in der zweiten Beschichtung zusätzlich oder alternativ zu dem Silbercarbonat, Silberlactat, Silberstearat oder Natriumcarbonat als die erfindungsgemäße Metallverbindung ein Silberoxid als Edelmetalloxid enthalten. Grundsätzlich werden bei dieser weiteren vorteilhaften Form der zweiten Partikel die erfindungsgemäßen Metallverbindungen bzw. das bevorzugte Edelmetalloxid bei einer Temperaturbehandlung des Ausgangswerkstoffes zu Silber reduziert. Dadurch weist die auf diese Weise aus dem Ausgangswerkstoff gebildete Sinterverbindung eine besonders hohe thermische und/oder elektrische Leitfähigkeit auf.

In Weiterbildung der Erfindung ist vorteilhafter Weise vorgesehen, dass die auf die ersten Partikel aufgetragene reduktionsmittelhaltige erste Beschichtung mindestens ein organisches Material als Reduktionsmittel beinhaltet, insbesondere mindestens einen Alkohol aus der Gruppe der primären oder sekundären Alkohole und/oder ein Amin und/oder Ameisensäure enthält. Ferner ist es besonders vorteilhaft, wenn das Reduktionsmittel eine Fettsäure, insbesondere eine Isostearinsäure, eine Stearinsäure, eine Ölsäure, eine Laurinsäure, oder eine Mischung verschiedener Fettsäuren. Die erfindungsgemäß vorgesehene erste Beschichtung, die ein Reduktionsmittel enthält, kann auch ausschließlich durch das Reduktionsmittel selbst, insbesondere durch die zuvor genannten Reduktionsmittel, gebildet sein.

Insgesamt lassen sich derartige reduktionsmittelhaltige erste Beschichtungen in einfacher Weise auf die ersten Partikeln aufbringen. Zusätzlich zeigen die genannten Reduktionsmittel im Rahmen einer Temperaturbehandlung des Ausgangswerkstoffes zur Ausbildung einer Sinterverbindung ein besonders gutes Reduktionsverhalten gegenüber der in der zweiten Beschichtung der zweiten Partikel enthaltenen erfindungsgemäßen Metallverbindungen bzw. Edelmetalloxide.

Grundsätzlich wandeln sich die erfindungsgemäßen Metallverbindungen oder Edelmetalloxide bei hohen Temperaturen in das zugrunde liegende elementare Metall oder Edelmetall um. Unter Einsatz einer reduktionsmittelhaltigen ersten Beschichtung erfolgt die Umwandlung der in der zweiten Beschichtung enthaltenen erfindungsgemäßen Metallverbindung und/oder des Edelmetalloxids zum elementaren Metall und/oder Edelmetall in vorteilhafter Weise bereits bei niedrigen Verarbeitungstemperaturen. Insbesondere bildet sich das elementare Metall und/oder Edelmetall bei einer Temperaturbehandlung des Ausgangswerkstoffes unterhalb der Sintertemperatur des elementaren Metalls und/oder Edelmetalls aus. Dadurch ist es möglich, dass in vorteilhafter Weise über die ausgebildete Sinterverbindung verbundene Fügepartner, beispielsweise elektrische und/oder elektronische Komponenten einer elektronischen Schaltung, keinen hohen Temperaturen während der Ausbildung der Sinterverbindung ausgesetzt werden. Somit können temperaturempfindliche elektrische und/oder elektronische Komponenten in elektronischen Schaltungen elektrisch und/oder thermisch kontaktiert werden, die auf Grund der sonst üblichen zu hohen Prozesstemperaturen bei der Verbindungsherstellung nicht eingesetzt werden konnten.

Insgesamt zeigt der erfindungsgemäße Ausgangswerkstoff eine sehr hohe Umwandlungsquote von bis zu 99 % oder mehr der in der zweiten Beschichtung enthaltenen erfindungsgemäßen Metallverbindungen und/oder Edelmetalloxiden zu dem elementaren Metall und/oder Edelmetall. Eine zumindest nahezu vollständige Umwandlung kann insbesondere dann erreicht werden, wenn der Anteil aus der erfindungsgemäßen Metallverbindung und/oder Edelmetalloxid zum Anteil des Reduktionsmittels in der reduktionsmittelhaltigen ersten Beschichtung in einem im Wesentlichen stöchiometrischen Verhältnis vorliegt. Nicht umgewandelte Anteile, die ansonsten in der Sinterverbindung aufgrund eines zu geringen Reduktionsmittelanteils verbleiben können, können die elektrische Leitfähigkeit der Sinterverbindung verringern.
Da auf Grund des stöchiometrischen Verhältnisses ein Überschuss an Reduktionsmittel ausgeschlossen ist, kann die Ausbildung einer Sinterverbindung aus dem Ausgangswerkstoff alternativ in einem Vakuum oder in einer Schutzgasatmosphäre ausgeführt werden. Liegt dagegen ein Überschuss an Reduktionsmittel vor, so wird eine Sauerstoffzufuhr, z.B. in Form einer Luftzufuhr, benötigt, um diesen vollständig auszubrennen.

In Weiterbildung des erfindungsgemäßen Ausgangswerkstoffes sind in vorteilhafter Weise zusätzlich weitere Partikel, enthaltend ein Element der vierten Hauptgruppe des Periodensystems, vorgesehen. Diese weiteren Partikel können dazu beitragen, vorteilhafte Eigenschaften bei der aus dem Ausgangswerkstoff gebildeten Sinterverbindung einzustellen.

Eine erste Möglichkeit ist gegeben, dem Ausgangswerkstoff bevorzugt weitere Partikel aus Silizium beizumischen. Silizium setzt man beispielsweise als Füllstoff dem Ausgangswerkstoff zu, wodurch der thermische Ausdehnungskoeffizient einer aus dem Ausgangswerkstoff gebildeten Sinterverbindung gesenkt wird. Zusätzlich weist Silizium eine hohe elektrische Leitfähigkeit auf. Partikel aus Silizium werden dem Ausgangswerkstoff darüber hinaus auch als kostengünstige Werkstoffalternative zu Silber bzw. zu Silberverbindungen zugesetzt. Dadurch kann der Anteil an Silber im Ausgangswerkstoff gering gehalten werden. Grundsätzlich verhalten sich Partikel aus Silizium während einer Temperaturbehandlung des Ausgangswerkstoffes zur Ausbildung einer Sinterverbindung in vorteilhafter Weise inert. Somit liegen Partikel aus Silizium bei einer gebildeten Sinterverbindung in unveränderter Form innerhalb einer Matrix der gebildeten Umwandlungsprodukte aus Metall und/oder Edelmetall vor.

Eine andere Möglichkeit ist gegeben, ebenso bevorzugt weitere Partikel aus Zinn und Blei dem Ausgangswerkstoff zuzugeben. Zinn und Blei bilden bei einer Temperaturbehandlung des Ausgangswerkstoffes Legierungen mit den Umwandlungsprodukten aus Metall und/oder Edelmetall aus, die aufgrund des stattfindenden Reduktionsprozesses entstehen. Diese Legierungen weisen einen gegenüber dem Metall und/oder Edelmetall geringeren Schmelzpunkt auf, wodurch die Verarbeitungstemperatur zur Ausbildung der Sinterverbindung weiter gesenkt werden kann. Ferner liegen die Legierungen dann als duktile Phasen innerhalb des gebildeten Sintergefüges vor, wodurch die gebildeten Sinterverbindungen weniger anfällig gegenüber thermischen und/oder mechanischen Belastungen, insbesondere wechselnden Belastungen sind. Ferner weist beispielsweise Zinn einen niedrigen Schmelzpunkt auf, sodass bei einer Temperaturbehandlung des Ausgangswerkstoffes die Partikel aus Zinn frühzeitig aufschmelzen und einen stoffschlüssigen Kontakt aller im Ausgangswerkstoff enthaltenen Partikel bewirken. Dies begünstigt in vorteilhafter Weise die während des Sinterprozesses ablaufenden Diffusionsvorgänge.

In Weiterbildung der Erfindung weisen die weiteren Partikel zusätzlich eine weitere Beschichtung auf. Die weitere Beschichtung, beispielsweise aus einem Edelmetall, verbessert insgesamt das Versintern der weiteren Partikel innerhalb des Sintergefüges einer aus dem Ausgangswerkstoff gebildeten Sinterverbindung. So werden beispielsweise weitere Partikel bevorzugt mit Silber und/oder Gold beschichtet.

Grundsätzlich von Vorteil ist es, wenn die im Ausgangswerkstoff enthaltenen ersten, zweiten und weiteren Partikel eine mittlere Korngröße von 0,01 - 50 µm, besonders bevorzugt von 0,1 - 10 µm, aufweisen. Infolge der größeren spezifischen Oberfläche ist eine erhöhte Reaktionsfähigkeit dieser Partikel gegeben. Dadurch kann die notwendige Verarbeitungstemperatur und die Prozesszeit zur Ausbildung einer Sinterverbindung gering gehalten werden.

Des Weiteren sind die ersten, zweiten und weiteren Partikel bevorzugt sphärisch und/oder plättchenförmig ausgebildet. Eine Mischung derartiger Partikelgeometrien ggf. zusammen mit kugelförmigen Partikeln ermöglicht eine hohe Dichte der aus dem Ausgangswerkstoff gebildeten Sinterverbindung.

Der Ausgangswerkstoff wird vorzugsweise als Paste bereitgestellt. Die Viskosität der Paste ist dabei maßgeblich durch das beigemischte Lösungsmittel einstellbar. Ebenso ist es von Vorteil, den Ausgangswerkstoff in Form einer Tablette oder als Formkörper, insbesondere als flachen Formkörper, bereitzustellen. In diesem Fall wird der pastenförmige Ausgangswerkstoff in eine Form gegeben oder auf eine Folie aufgetragen. Anschließend wird das Lösungsmittel mittels einer Temperaturbehandlung aus dem Ausgangswerkstoff ausgetrieben. Hier ist ein Lösungsmittel vorzusehen, welches bereits bei einer Temperatur, die unterhalb der eigentlichen Sintertemperatur des Ausgangswerkstoffs liegt, rückstandsfrei ausgetrieben werden kann. Der auf diese Weise gebildete Ausgangswerkstoff kann auch als Großnutzen gefertigt werden, welcher dann zu kleinen anwendungsspezifischen Formkörpern geschnitten wird.

Grundsätzlich kann die erste, die zweite und die weitere Beschichtung der im Ausgangswerkstoff enthaltenen ersten, zweiten und/oder weiteren Partikeln mit Hilfe bekannter Beschichtungsverfahren ausgeführt werden. Diese können aus bekannter technischer Literatur entnommen werden. Beispielhaft sind hierbei chemische und physikalische Beschichtungsverfahren zu nennen, wie zum Beispiel eine chemische bzw. physikalische Gasphasenabscheidung.

Bisherige Versuche zeigen, dass die aus dem erfindungsgemäßen Ausgangswerkstoff gebildete Sinterverbindung die elektrische Leitfähigkeit von reinem Silber erreichen kann, zumindest aber einen Wert der elektrischen Leitfähigkeit aufweist, der nur gering unter dem von reinem Silber liegt. Zusätzlich weist die gebildete Sinterverbindung eine thermische Leitfähigkeit von >100 W/mK auf.

Die Erfindung betrifft weiterhin auch ein Verfahren zur Ausbildung einer thermisch und/oder elektrisch leitenden Sinterverbindung. Ausgegangen wird hierbei von einem Ausgangswerkstoff der vorbeschriebenen Art, der zwischen zwei Fügepartner gebracht wird. Bevorzugte Fügepartner sind elektrische und/oder elektronische Komponenten mit Kontaktstellen, die in unmittelbaren physischen Kontakt mit dem Ausgangswerkstoff gebracht werden. Hierbei kann der Ausgangswerkstoff in Form einer Druckpaste beispielsweise mittels Sieb- oder Schablonendruck auf die Kontaktstellen aufgetragen werden. Ebenso ist der Auftrag durch Injekt- oder Dispensverfahren möglich. Eine sehr einfache Möglichkeit besteht weiterhin darin, den Ausgangswerkstoff als Formkörper zwischen den Fügepartner anzuordnen.

Anschließend wird die Sinterverbindung durch eine Temperaturbehandlung des Ausgangswerkstoffes ausgebildet. Unter Zufuhr von Wärme reagiert die im Ausgangswerkstoff zumindest anteilig enthaltene erfindungsgemäße Metallverbindung bzw. das Edelmetalloxid und das in der ersten Beschichtung enthaltenen Reduktionsmittel miteinander. Dabei handelt es sich um einen Reduktionsprozess, bei welchem die in der zweiten Beschichtung enthaltene erfindungsgemäße Metallverbindung und/oder das Edelmetalloxid zu dem zugrundeliegenden elementaren Metall und/oder Edelmetall reduziert werden.

Der Reduktionsprozess beginnt dabei in vorteilhafter Weise bereits unterhalb der Sintertemperatur des elementaren Metalls und/oder Edelmetalls. Es wird daher eine Verarbeitungstemperatur von < 400°C vorgesehen, bevorzugt von < 300°C, insbesondere von < 250°C. Ggf. wird zur Verbesserung des Sintervorgangs dieser unter Druck ausgeführt. Als Prozessdruck wird ein Druck < 4MPa vorgesehen, bevorzugt < 1,6 MPa, besonders bevorzugt < 0,8 MPa. Überschüssiges Reduktionsmittel wird unter der Voraussetzung einer ausreichenden Sauerstoffzufuhr vollkommen ausgebrannt, beispielsweise unter Luftatmosphäre. Bevorzugt sind Fügepartner mit Kontaktstellen aus einem Edelmetall vorgesehen, beispielsweise aus Gold, Silber oder einer Legierung aus Gold oder Silber.

Bei einer alternativen Möglichkeit des erfindungsgemäßen Verfahrens wird die Sinterverbindung im Vakuum und/oder unter einer Stickstoffatmosphäre ausgebildet. Da in diesem Fall überschüssiges Reduktionsmittel nicht verbrannt werden kann, ist ein Ausgangswerkstoff mit ersten und zweiten Partikel vorzusehen, bei welchem der Anteil aus der erfindungsgemäßen Metallverbindung und/oder Edelmetalloxid in der zweiten Beschichtung zum Anteil des Reduktionsmittels in der ersten Beschichtung in einem stöchiometrischen Verhältnis vorliegt. Während der Temperaturbehandlung wird das Reduktionsmittel demzufolge vollkommen aufgebraucht. Zusätzlich ist die erfindungsgemäße Metallverbindung und/oder das Edelmetalloxid vollständig in das elementare Metall und/oder Edelmetall umgewandelt. In vorteilhafter Weise können bei dieser Verfahrensalternative auch Fügepartner mit einer nicht edelmetallhaltigen Kontaktstelle vorgesehen werden, die beispielsweise aus Kupfer ausgebildet ist. Somit können auch kostengünstige elektrische und oder elektronische Komponenten herangezogen werden. Ferner sind durch Wegfall eines ansonsten notwendigen Prozessdruckes die vorgesehenen elektrischen und/oder elektronischen Komponenten keinen mechanischen Belastungen ausgesetzt.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1: schematisch erste und zweite Partikel eines erfindungsgemäßen Ausgangswerkstoffs einer Sinterverbindung ,
- Fig. 2a: schematisch eine Mischung von Partikeln in einem erfindungsgemäßen Ausgangswerkstoff mit ersten und zweiten Partikeln entsprechend der Fig. 1 und weiteren Partikeln aus Silizium
- Fig. 2b: schematisch eine weitere Mischung von Partikeln in einem erfindungsgemäßen Ausgangswerkstoff mit Partikeln entsprechend der Fig. 1 und weiteren Partikeln aus Zinn,
- Fig. 3: schematisch eine Schnittdarstellung eines Sinterofens und einer im Sinterofen angeordneten elektronischen Schaltung, wobei die elektronische Schaltung zwischen einem Chip und einem Substrat einen erfindungsgemäßen Ausgangswerkstoff ausweist.

### Ausführungsformen der Erfindung

In den Figuren sind gleiche Bauteile und Bauteile mit der gleichen Funktion mit den gleichen Bezugszeichen gekennzeichnet.

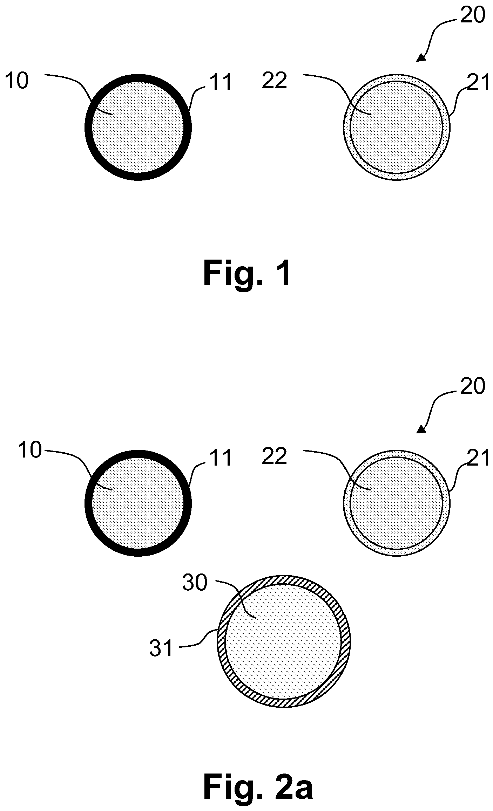

In Fig. 1 sind schematisch erste Partikel 10 und zweite Partikel 20 gezeigt, die in einer ersten Ausführungsform in einem erfindungsgemäßen Ausgangswerkstoff einer Sinterverbindung vorgesehen sind. Die Partikel 10 sind dabei aus Silber gebildet und weisen eine erste Beschichtung 11 auf, die ein Reduktionsmittel enthält. Konkret besteht in diesem Beispiel die Beschichtung 11 aus einer Fettsäure. Weiter ist gezeigt, dass die zweiten Partikel 20 einen metallischen Kern 22 umfassen und eine auf dem metallischen Kern 22 aufgetragene zweite Beschichtung 21. Die Beschichtung 21 enthält dabei zumindest anteilig eine erfindungsgemäße Metallverbindung und/oder ein Edelmetalloxid. Im vorliegenden Beispiel ist der Kern 22 der zweiten Partikel 20 aus Silber gebildet. Dieser ist dann bevorzugt vollständig von einer dünnen Beschichtung 21 aus Ag₂CO₃, Ag₂O oder AgO umschlossen. Der Anteil der Fettsäure auf den ersten Partikel 10 ist derart gewählt, dass er in einem stöchiometrischen Verhältnis zu dem Anteil der in den zweiten Beschichtung 21 der zweiten Partikel 20 enthaltenen erfindungsgemäße Metallverbindung aus Ag₂CO3, Ag₂O oder AgO vorliegt. Die ersten Partikel 10 mit der ersten Beschichtung 11 aus einer Fettsäure und die zweiten Partikel 20 liegen in beispielsweise dispergierter Form beispielsweise als Paste vor.

Ein erfindungsgemäßer Ausgangswerkstoff kann optional neben den ersten Partikel 10 mit der ersten Beschichtung 11 und den zweiten Partikel 20 entsprechend der Fig. 1 zusätzlich weitere Partikel enthalten.

So zeigt beispielsweise Fig. 2a eine Mischung von Partikeln, die in einem erfindungsgemäßen Ausgangswerkstoff enthalten sein können. Die Mischung weist erste Partikel 10 mit einer ersten Beschichtung 11 und zweite Partikel 20 entsprechend Fig. 1 sowie zusätzlich weitere Partikel 30 aus Silizium auf. Die weiteren Partikel 30 sind zusätzlich mit einer weiteren Beschichtung 31 aus einer Silberverbindung versehen.

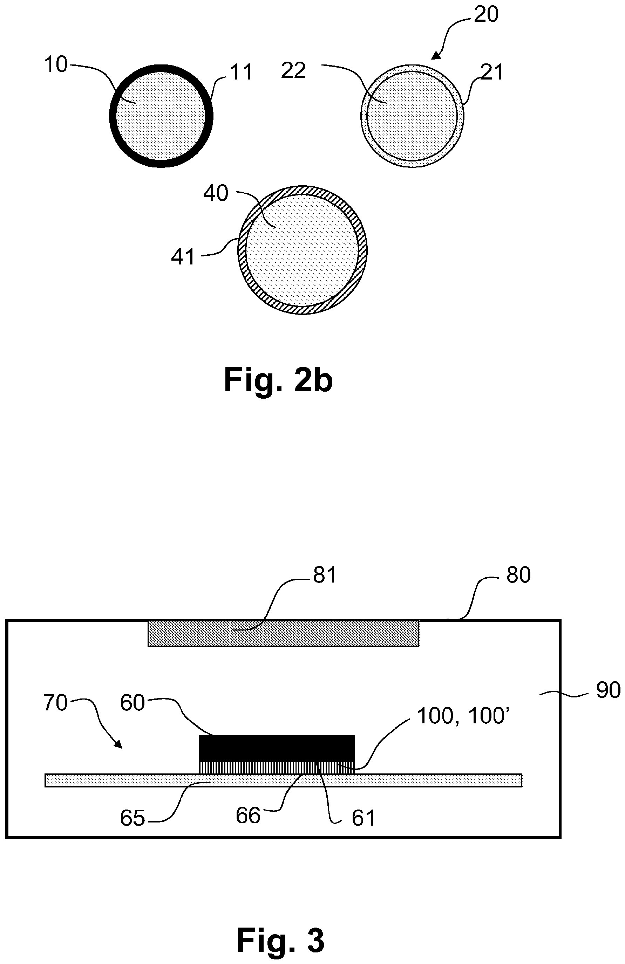

Die Fig. 2b zeigt schematisch eine weitere in einem Ausgangswerkstoff bevorzugt vorgesehene Mischung von Partikeln. Hierbei liegen neben ersten Partikeln 10 mit einer ersten Beschichtung 11 und zweiten Partikeln 20 entsprechend Fig. 1 zusätzlich weitere Partikel 40 aus Zinn als Mischung vor. Ferner ist auf den weiteren Partikeln 40 aus Zinn eine weitere Beschichtung 41 aus einer Silberverbindung vorgesehen.

Die in dem Ausgangswerkstoff enthaltenen ersten Partikel 10, zweiten Partikel 20 und/oder weiteren Partikel 30 bzw. 40 weisen eine Partikelgröße zwischen 0,01 - 50 µm auf. Die ersten und zweiten Partikel 10 bzw. 20 sind bevorzugt kleiner ausgeführt als die weiteren Partikel 30 bzw. 40, zum Beispiel mit einem Durchmesser zwischen 0,1 - 10 µm.

In Fig. 3 ist ein Sinterofen 80 gezeigt, sowie eine in einem Prozessraum 90 des Sinterofens 80 angeordnete elektronische Schaltung 70. Die elektronische Schaltung 70 weist ein Substrat 65 mit mindestens einer ersten Kontaktstelle 66 aus Kupfer auf. Auf dem Substrat 65 ist ein Chip 60 mit zumindest einer zweiten Kontaktstelle 61 aus einer Silberlegierung angeordnet. Zwischen der mindestens ersten Kontaktstelle 66 aus Kupfer und der zumindest zweiten Kontaktstelle 61 aus der Silberlegierung ist ein erfindungsgemäßer Ausgangswerkstoff 100 als Paste aufgetragen. Der Ausgangswerkstoff 100 enthält dabei anteilig eine Mischung von Partikeln 10, 20, 30 bzw. 10, 20, 40 entsprechend den Fig. 2a und 2b.

Zur Ausbildung einer Sinterverbindung 100' zwischen der mindestens ersten Kontaktstelle 66 des Substrates 65 und der zumindest zweiten Kontaktstelle 61 des Chips 60, wird die elektronische Schaltung 70 mit dem enthaltenen Ausgangswerkstoff 100 einer Temperaturbehandlung unterzogen. Zur Durchführung der Temperaturbehandlung enthält der Sinterofen 80 innerhalb des Prozessraumes 90 eine Heizvorrichtung 81. Im Prozessraum 90 liegt während der Temperaturbehandlung des Ausgangswerkstoffes 100 beispielsweise ein Vakuum oder eine Schutzgasatmosphäre vor.

Infolge der Temperaturbehandlung der elektronischen Schaltung 70 werden im Ausgangswerkstoff 100 chemische Reaktionsprozesse ausgelöst. So wird mittels der als erste Beschichtung 11 auf den ersten Partikel 10 vorliegenden Fettsäure ein Reduktionsprozess im Ausgangswerkstoff 100 gestartet. Dabei wirkt die Fettsäure als Reduktionsmittel, welche die innerhalb der zweiten Beschichtung 21 der zweiten Partikel 20 enthaltene erfindungsgemäße Metallverbindung aus Ag₂CO₃, Ag₂O und/oder AgO zu elementarem Silber reduziert. Diese Reduktion erfolgt bereits bei einer Temperatur unterhalb der Sintertemperatur von Silber.

Infolge der stöchiometrischen Verteilung der als erste Beschichtung 11 vorliegenden Fettsäure auf den ersten Partikel 10 zum Anteil der in der zweiten Beschichtung 21 der Partikel 20 enthaltenen erfindungsgemäße Metallverbindung aus Ag₂CO₃, Ag₂O oder AgO, erfolgt eine weitestgehend vollständige Umwandlung der zweiten Beschichtung 21 in Silber. Zusätzlich verbleiben weitestgehend keine Reste an Fettsäure in der gebildeten Sinterverbindung 100', die ansonsten bei einem verbleibenden Rest von <1% unter Sauerstoffzufuhr ausgebrannt werden müssten.
Der metallische Kern 22 der zweiten Partikel 20 versintert mit der auf dem Kern 22 angeordneten und nun in Silber umgewandelten zweiten Beschichtung 21 und bildet eine Silbermatrix als einen Teil des Sintergefüges der sich bildenden Sinterverbindung 100' aus. Zusätzlich sind in der Silbermatrix auch die ersten Partikel 10 aus Silber mitversintert. Ebenso erfolgt mittels der gebildeten Sinterverbindung 100' eine Kontaktierung der ersten und zweiten Kontaktstelle 61, 66 des Substrates bzw. des Chips 65. Eine Kontaktierung der ersten Kontaktstelle 66 aus Kupfer während der Temperaturbehandlung ohne Korrosionserscheinungen ist möglich, da die Kontaktierung unter Vakuum oder einer Schutzgasatmosphäre erfolgt. Dadurch bleibt ein unedles Material, wie beispielsweise aus Kupfer, auch während der Temperaturbehandlung zur Ausbildung der Sinterverbindung 100' frei von Oxidationsprodukten.

Die in dem Ausgangswerkstoff 100 als Mischung mit den ersten und zweiten Partikeln 10 bzw. 20 enthaltenen weiteren Partikel 40 aus Zinn schmelzen während der Temperaturbehandlung frühzeitig auf und unterstützen einen stofflichen Kontakt aller im Ausgangswerkstoff 100 enthaltenen Partikel 10, 20, 30, 40. Zusätzlich bildet das Zinn der weiteren Partikel 40 Legierungen mit dem Silber der gebildeten Silbermatrix. Diese Legierungen liegen dann als duktile Phasen innerhalb der im Sintergefüge ausgebildeten Silbermatrix vor.

Die ebenfalls als Mischung im Ausgangswerkstoff 100 enthaltenen weiteren Partikel 30 aus Silizium verhalten sich während des Sintervorgangs inert. Dabei unterstützt die auf den weiteren Partikel 30 aufgetragene weitere Beschichtung 31 aus der Silberverbindung die Versinterung innerhalb des Sintergefüges. Die weiteren Partikel 30 aus Silizium liegen nach Ausbildung der Sinterverbindung 100' fein verteilt innerhalb der Silbermatrix des Sintergefüges 100' vor.

## Patentansprüche

1. Ausgangswerkstoff für eine Sinterverbindung (100'), umfassend erste Partikel (10) aus mindestens einem Metall mit einer auf den ersten Partikeln (10) aufgetragenen ersten Beschichtung (11) aus einem organischen Material, sowie zweite Partikel 20, die ein Silbercarbonat, ein Silberlactat, ein Silberstearat oder ein Natriumcarbonat und/oder ein Edelmetalloxid enthalten, wobei das Silbercarbonat, das Silberlactat, das Silberstearat oder das Natriumcarbonat und/oder das Edelmetalloxid bei einer Temperaturbehandlung des Ausgangswerkstoffes (100) in das zugrunde liegende elementare Metall und/oder Edelmetall umgewandelt werden,
**dadurch gekennzeichnet, dass**
die zweiten Partikel (20) einen Kern (22) mindestens eines Metalls umfassen, sowie eine auf dem Kern (22) aufgetragene zweite Beschichtung (21) enthaltend das Silbercarbonat, das Silberlactat, das Silberstearat oder das Natriumcarbonat und/oder das Edelmetalloxid, und dass die erste Beschichtung (11) ein Reduktionsmittel enthält, mittels welchem die Reduktion des Silbercarbonats, des Silberlactats, des Silberstearats oder des Natriumcarbonats und/oder des Edelmetalloxids zu dem elementaren Metall und/oder Edelmetall bei einer Temperatur unterhalb der Sintertemperatur des elementaren Metalls und/oder Edelmetalls erfolgt.

2. Ausgangswerkstoff nach Anspruch 1,
**dadurch gekennzeichnet, dass**
die ersten Partikel (10) und/oder der metallische Kern (22) der zweiten Partikel (20) ein Edelmetall enthält.

3. Ausgangswerkstoff nach Anspruch 2,
**dadurch gekennzeichnet, dass**
die ersten Partikel (10) und/oder der metallische Kern (22) der zweiten Partikel (20) Silber, Gold, Platin, Palladium und/oder Kupfer enthalten.

4. Ausgangswerkstoff nach einem der vorhergehenden Ansprüche,
**dadurch gekennzeichnet, dass**
die erste Beschichtung (11) mindestens einen Alkohol aus der Gruppe der primären oder sekundären Alkohole und/oder ein Amin und/oder eine Ameisensäure beinhaltet.

5. Ausgangswerkstoff nach einem der vorhergehenden Ansprüche,
**dadurch gekennzeichnet, dass**
das in der ersten Beschichtung (11) enthaltene organische Material eine Fettsäure ist, insbesondere eine Isostearinsäure, eine Stearinsäure, eine Ölsäure, eine Laurinsäure, oder dass es eine Mischung verschiedener Fettsäuren ist.

6. Ausgangswerkstoff nach einem der vorhergehenden Ansprüche,
**dadurch gekennzeichnet, dass**
das in der zweiten Beschichtung (21) enthaltene Edelmetalloxid ein Silberoxid ist.

7. Ausgangswerkstoff nach einem der vorhergehenden Ansprüche,
**dadurch gekennzeichnet, dass**
der Anteil des Silbercarbonats, des Silberlactats, des Silberstearats oder des Natriumcarbonatsund/oder des Edelmetalloxids in der zweiten Beschichtung (21) zum Anteil des Reduktionsmittels in der ersten Beschichtung (11) in einem stöchiometrischen Verhältnis vorliegt.

8. Ausgangswerkstoff nach einem der vorhergehenden Ansprüche,
**dadurch gekennzeichnet, dass**
zusätzlich weitere Partikel (30, 40) enthaltend ein Element der vierten Hauptgruppe des Periodensystems vorgesehen sind.

9. Ausgangswerkstoff nach Anspruch 8
**dadurch gekennzeichnet, dass**
die weiteren Partikel (30, 40) eine weitere Beschichtung (31, 41) aus einem Edelmetall oder einer organischen Beschichtung aufweisen.

10. Ausgangswerkstoff nach einem der vorhergehenden Ansprüche,
**dadurch gekennzeichnet, dass**
die ersten, die zweiten und/oder weiteren Partikel (10, 20, 30, 40) eine mittlere Korngröße von 0,01 - 50 µm aufweisen.

11. Verfahren zur Ausbildung einer thermisch und/oder elektrisch leitenden Sinterverbindung (100'), wobei ein Ausgangswerkstoff (100) für eine Sinterverbindung (100') nach einem der Ansprüche 1 bis 10 vorgesehen wird, umfassend folgende Schritte:
- Bereitstellen des Ausgangsstoffes (100)
- Ausbilden der Sinterverbindung (100') durch die Temperaturbehandlung des Ausgangswerkstoffes (100), wobei bei einer Temperatur unterhalb der Sintertemperatur des elementaren Metalls und/oder des Edelmetalls das in der zweiten Beschichtung (21) enthaltene Silbercarbonat, Silberlactat, Silberstearat oder Natriumcarbonat und/oder das Edelmetalloxid mittels dem in der ersten Beschichtung (11) enthaltenem Reduktionsmittel zum elementaren Metall und/oder Edelmetall reduziert werden.

12. Verfahren nach Anspruch 11,
**dadurch gekennzeichnet, dass**
die Sinterverbindung (100') bei einer Temperatur unterhalb 500°C, vorzugsweise unterhalb 250°C, ausgebildet wird.

13. Verfahren nach einem der Ansprüche 11 oder 12,
**dadurch gekennzeichnet, dass**
die Sinterverbindung (100') im Vakuum und/oder in einer Stickstoffatmosphäre ausgebildet wird.

14. Verfahren nach einem der Ansprüche 11 bis 13,
**dadurch gekennzeichnet, dass**
der Ausgangswerkstoff (100) in Form einer Druckpaste, insbesondere für einen Sieb- oder Schablonendruck, oder für ein Inkjet-Auftrageverfahren, oder als Formteil ausgebildet wird.

## Claims

1. Starting material for a sintered bond (100'), which comprises first particles (10) composed of at least one metal having a first coating (11) which is applied to the first particles (10) and is composed of an organic material, and second particles (20) which contain a silver carbonate, a silver lactate, a silver stearate or a sodium carbonate and/or or a noble metal oxide, where the silver carbonate, the silver lactate, the silver stearate or the sodium carbonate and/or the noble metal oxide are converted in a thermal treatment of the starting material (100) into the parent elemental metal and/or noble metal,
**characterized in that**
the second particles (20) comprise a core (22) of at least one metal, and a second coating (21) which is applied to the core (22) and contains the silver carbonate, the silver lactate, the silver stearate or the sodium carbonate and/or the noble metal oxide, and **in that** the first coating (11) contains a reducing agent by means of which the silver carbonate, the silver lactate, the silver stearate or the sodium carbonate and/or the noble metal oxide are reduced to the elemental metal and/or noble metal at a temperature below the sintering temperature of the elemental metal and/or noble metal.

2. Starting material according to Claim 1,
**characterized in that**
the first particles (10) and/or the metallic core (22) of the second particles (20) contains a noble metal.

3. Starting material according to Claim 2,
**characterized in that**
the first particles (10) and/or the metallic core (22) of the second particles (20) contain silver, gold, platinum, palladium and/or copper.

4. Starting material according to any of the preceding claims,
**characterized in that**
the first coating (11) comprises at least one alcohol selected from the group consisting of primary and secondary alcohols, and/or an amine and/or a formic acid.

5. Starting material according to any of the preceding claims,
**characterized in that**
the organic material present in the first coating (11) is a fatty acid, in particular an isostearic acid, a stearic acid, an oleic acid, a lauric acid, or **in that** it is a mixture of various fatty acids.

6. Starting material according to any of the preceding claims,
**characterized in that**
the noble metal oxide present in the second coating (21) is a silver oxide.

7. Starting material according to any of the preceding claims,
**characterized in that**
the proportion of the silver carbonate, the silver lactate, the silver stearate or the sodium carbonate and/or the noble metal oxide in the second coating (21) is in a stoichiometric ratio to the proportion of the reducing agent in the first coating (11).

8. Starting material according to any of the preceding claims,
**characterized in that**
further particles (30, 40) containing an element of the fourth main group of the Periodic Table are additionally provided.

9. Starting material according to Claim 8,
**characterized in that**
the further particles (30, 40) have a further coating (31, 41) composed of a noble metal or an organic coating.

10. Starting material according to any of the preceding claims,
**characterized in that**
the first, the second and/or further particles (10, 20, 30, 40) have an average particle size of 0.01-50 µm.

11. Process for forming a thermally and/or electrically conductive sintered bond (100'), where a starting material (100) for a sintered bond (100') according to any of Claims 1 to 10 is provided, which comprises the following steps:
- provision of the starting material (100),
- formation of the sintered bond (100') by thermal treatment of the starting material (100), where the silver carbonate, silver lactate, silver stearate or sodium carbonate present in the second coating (21) and/or the noble metal oxide are reduced to the elemental metal and/or noble metal by means of the reducing agent present in the first coating (11) at a temperature below the sintering temperature of the elemental metal and/or the noble metal.

12. Process according to Claim 11,
**characterized in that**
the sintered bond (100') is formed at a temperature below 500°C, preferably below 250°C.

13. Process according to either Claim 11 or 12,
**characterized in that**
the sintered bond (100') is formed under reduced pressure and/or in a nitrogen atmosphere.

14. Process according to any of Claims 11 to 13,
**characterized in that**
the starting material (100) is in the form of a printing paste, in particular for screen printing or stenciling, or for an ink jet application process, or in the form of a shaped part.

## Revendications

1. Matériau de départ pour un composé fritté (100'), comprenant des premières particules (10) composées d'au moins un métal dotées d'un premier revêtement (11) appliqué sur les premières particules (10) composé d'un matériau organique, ainsi que des deuxièmes particules (20), qui contiennent un carbonate d'argent, un lactate d'argent, un stéarate d'argent ou un carbonate de sodium et/ou un oxyde de métal noble, le carbonate d'argent, le lactate d'argent, le stéarate d'argent ou le carbonate de sodium et/ou l'oxyde de métal noble étant transformés en métal et/ou en métal noble élémentaires sous-jacents par un traitement de température du matériau de départ (100),
**caractérisé en ce que**
les deuxièmes particules (20) comprennent un noyau (22) d'au moins un métal, ainsi qu'un deuxième revêtement (21), appliqué sur le noyau (22), contenant le carbonate d'argent, le lactate d'argent, le stéarate d'argent ou le carbonate de sodium et/ou l'oxyde de métal noble, et **en ce que** le premier revêtement (11) contient un agent de réduction, au moyen duquel la réduction du carbonate d'argent, du lactate d'argent, du stéarate d'argent ou du carbonate de sodium et/ou de l'oxyde de métal noble en métal et/ou en métal noble élémentaires est réalisée à une température inférieure à la température de frittage du métal et/ou du métal noble élémentaires.

2. Matériau de départ selon la revendication 1, **caractérisé en ce que** les premières particules (10) et/ou le noyau métallique (22) des deuxièmes particules (20) contien(nen)t un métal noble.

3. Matériau de départ selon la revendication 2, **caractérisé en ce que** les premières particules (10) et/ou le noyau métallique (22) des deuxièmes particules (20) contien(nen)t de l'argent, de l'or, du platine, du palladium et/ou du cuivre.

4. Matériau de départ selon l'une quelconque des revendications précédentes, **caractérisé en ce que** le premier revêtement (11) contient au moins un alcool du groupe des alcools primaires ou secondaires et/ou une amine et/ou un acide formique.

5. Matériau de départ selon l'une quelconque des revendications précédentes, **caractérisé en ce que** le matériau organique contenu dans le premier revêtement (11) est un acide gras, en particulier un acide isostéarique, un acide stéarique, un acide oléique, un acide laurique, ou **en ce qu'**il s'agit d'un mélange de différents acides gras.

6. Matériau de départ selon l'une quelconque des revendications précédentes, **caractérisé en ce que** l'oxyde de métal noble contenu dans le deuxième revêtement (21) est un oxyde d'argent.

7. Matériau de départ selon l'une quelconque des revendications précédentes, **caractérisé en ce que** la proportion du carbonate d'argent, du lactate d'argent, du stéarate d'argent ou du carbonate de sodium et/ou de l'oxyde de métal noble dans le deuxième revêtement (21) par rapport à la proportion de l'agent de réduction dans le premier revêtement (11) est présente en un rapport stœchiométrique.

8. Matériau de départ selon l'une quelconque des revendications précédentes, **caractérisé en ce que** de plus des particules supplémentaires (30, 40) contenant un élément du quatrième groupe principal du système périodique sont prévues.

9. Matériau de départ selon la revendication 8, **caractérisé en ce que** les particules supplémentaires (30, 40) présentent un revêtement supplémentaire (31, 41) composé d'un métal noble ou d'un revêtement organique.

10. Matériau de départ selon l'une quelconque des revendications précédentes, **caractérisé en ce que** les premières particules, les deuxièmes particules et/ou les particules supplémentaires (10, 20, 30, 40) présentent une granulométrie moyenne de 0,01 à 50 µm.

11. Procédé pour la formation d'un composé fritté (100') conducteur thermiquement et/ou électriquement, un matériau de départ (100) pour un composé fritté (100') selon l'une quelconque des revendications 1 à 10 étant prévu, comprenant les étapes suivantes :
- mise à disposition du matériau de départ (100)
- formation du composé fritté (100') par le traitement de température du matériau de départ (100), où à une température inférieure à la température de frittage du métal et/ou du métal noble élémentaires, le carbonate d'argent, le lactate d'argent, le stéarate d'argent ou le carbonate de sodium et/ou l'oxyde de métal noble contenus dans le deuxième revêtement (21) sont réduits en métal et/ou en métal noble élémentaires au moyen de l'agent de réduction contenu dans le premier revêtement (11).

12. Procédé selon la revendication 11, **caractérisé en ce que** le composé fritté (100') est formé à une température inférieure à 500 °C, de préférence inférieure à 250 °C.

13. Procédé selon l'une quelconque des revendications 11 et 12, **caractérisé en ce que** le composé fritté (100') est formé sous vide et/ou dans une atmosphère d'azote.

14. Procédé selon l'une quelconque des revendications 11 à 13, **caractérisé en ce que** le matériau de départ (100) est formé sous la forme d'une pâte d'impression, en particulier pour une sérigraphie ou une impression au pochoir, ou pour un procédé d'application par jet d'encre, ou en tant que pièce moulée.
